# FASCICULE DE BREVET EUROPEEN

(11) **EP 3 502 735 B1**
(45) Date de publication et mention de la délivrance du brevet: **30.06.2021**
(21) Numéro de dépôt: 18206388.3
(22) Date de dépôt: 15.11.2018
(51) Int. Cl.: G01S 7/41, G01S 13/78, G01S 7/40

(54) **PROCÉDÉ DE MESURE DE DIAGRAMMES D'ANTENNE D'UN RADAR SECONDAIRE ET RADAR SECONDAIRE METTANT EN OEUVRE UN TEL PROCÉDÉ**
MESSVERFAHREN VON ANTENNENDIAGRAMMEN EINES SEKUNDÄREN RADARS, UND SEKUNDÄRER RADAR, DER DIESES VERFAHREN UMSETZT
METHOD FOR MEASURING ANTENNA PATTERNS OF A SECONDARY RADAR AND SECONDARY RADAR IMPLEMENTING SUCH A METHOD

(30) Priorité: 19.12.2017 FR 1701322
(43) Date de publication de la demande: 26.06.2019
(73) Titulaire: Thales, 92400 Courbevoie (FR)
(72) Inventeur: BILLAUD, Philippe, 91470 Limours (FR)
(74) Mandataire: Marks & Clerk France

(56) Documents cités:
- EP-A1- 0 389 343
- EP-A1- 0 506 527
- EP-A1- 3 076 199
- GB-A- 2 194 407
- US-A1- 2008 042 896
- US-A1- 2012 001 793

## Description

La présente invention concerne un procédé de mesure de diagrammes d'antenne d'un radar secondaire. Elle concerne également un radar secondaire mettant en œuvre un tel procédé.

Le domaine de l'invention est notamment le Contrôle du Trafic Aérien (ATC) pour lequel la performance du radar est fondamentale tant au niveau de la détection des aéronefs, avec un objectif approchant les 100%, que du taux de fausse détection très faible, avec un objectif approchant le 0%.
L'invention trouve aussi sa place dans le domaine militaire (IFF) pour lequel la performance du radar est tout aussi fondamentale pour l'identification « ami/ennemi » des aéronefs.

Dans les deux applications, les performances sont particulièrement liées à la qualité des diagrammes de l'antenne, antenne de type LVA (« Large Vertical Aperture ») ou de type poutre, équipant le radar employé en ATC ou en IFF.

Actuellement, la mesure de qualité des diagrammes sur une antenne installée sur un site radar nécessite à la fois :
- le passage en maintenance de la station, ce qui diminue la couverture radar au niveau système ;
- d'employer un outillage externe pour mesurer en émission (1030 MHz) les trois diagrammes (quelquefois deux ou quatre diagrammes) de l'antenne somme (SUM), contrôle (CONT) et différence (DIFF).
Il est à noter que les mesures en émission ne sont effectuées que pour la valeur d'élévation de l'outillage, à une valeur très faible d'élévation souvent proche de zéro alors que les avions se situent principalement entre 0,5° et 20° selon le type d'emploi du radar (configuration « aéroport » ou « EnRoute »).

Entre les mesures périodiques préventives des diagrammes d'antenne, la dégradation de ceux-ci n'est alors perçue par les utilisateurs que lorsque les performances du radar sont dégradées quelquefois au point de ne plus remplir sa mission. Dans ce cas, l'interruption de service est alors imposée temporellement et la réparation de l'antenne est à effectuer en urgence sachant qu'il s'agit de la plus importante et compliquée tâche de maintenance d'un radar.
Une maintenance efficace des antennes radar est donc un réel besoin technique à résoudre.
Un document GB 2 194 407 A divulgue un procédé de mesure de diagramme d'antenne utilisant les réponses synchrones émises par des cibles présentes dans l'espace aérien. Un document US 2008/042896 A1 divulgue une table de calibration monopulse à partir de cibles d'opportunité pour un radar secondaire.

Un but de l'invention est notamment de résoudre ce problème. A cet effet, l'invention a pour objet un procédé de mesure des diagrammes d'antenne en gisement d'un radar secondaire par tranche d'élévation, chaque diagramme étant associé à une voie de réception, ledit procédé utilisant les réponses synchrones et les réponses asynchrones, non sollicitées de type Fruit, émises par des cibles présentes dans l'environnement aérien dudit radar et détectées sur un nombre de tours d'antenne donné, à chaque détection d'une réponse, l'heure de ladite détection, la valeur de l'azimut du faisceau principal de l'antenne et la valeur de puissance reçue sur chacune desdites voies étant associées à ladite détection, chaque réponse asynchrone étant enrichie de son gisement, de sa puissance relative par diagramme et de son élévation par différence avec les mêmes valeurs extrapolées de ladite réponse synchrone à l'heure du Fruit, lesdites valeurs obtenues sur le nombre de tours donné étant mémorisées, les diagrammes mesurés étant échantillonnés à partir desdites valeurs mémorisées.

On calcule pour chaque réponse asynchrone d'une cible :
- son gisement antenne : par extrapolation de la position synchrone de ladite cible en azimut à l'heure de détection du Fruit et de la position de l'antenne en azimut à l'heure de détection du Fruit ;
- sa puissance relative : par extrapolation de la puissance desdites réponses synchrones, acquises avec le faisceau principal de la voie somme de l'antenne, de ladite cible encadrant temporellement l'heure de détection du Fruit à l'heure du Fruit et de la puissance du Fruit sur chacun des diagrammes de l'antenne ;
- son élévation : par extrapolation de l'élévation, reçue dans les réponses synchrones, de ladite cible encadrant temporellement l'heure de détection du Fruit à l'heure du Fruit.

Ladite antenne comporte par exemple un des ensembles de diagrammes suivant :
- un diagramme somme (SUM), un diagramme différence (DIFF), un diagramme de contrôle pour rejeter des réponses de cibles face à l'antenne (CONT_Front) et un diagramme de contrôle pour rejeter des cibles à l'arrière de l'antenne (CONT_Back) ;
- un diagramme somme (SUM), un diagramme différence (DIFF), un diagramme de contrôle (CONT);
- un diagramme somme (SUM) et un diagramme différence et contrôle (DIFF/CONT).

Les réponses de type Fruit et les réponses synchrones sont par exemple enrichies par des caractéristiques représentatives de l'acquisition desdites réponses, lesdites caractéristiques étant pour chaque réponse au moins l'une des caractéristiques suivantes :
- puissance reçue selon chaque diagramme de ladite antenne ;
- heure de la détection de ladite réponse ;
- azimut du faisceau principal de ladite antenne lors de ladite détection.

La détection d'une réponse de type Fruit est par exemple enrichie par des informations obtenues à partir des réponses synchrones obtenues lors des tours entourant le tour de détection de ladite réponse de type Fruit, ces informations étant l'une au moins des caractéristiques suivantes :
- puissance relative de la dite réponse de type Fruit ;
- gisement de ladite réponse de type Fruit ;
- élévation de ladite réponse de type Fruit.

Sur le nombre de tours donné, on accumule par exemple dans des tableaux à deux entrées la puissance relative d'une réponse de type Fruit ou synchrone en fonction de la puissance de la cible sur le diagramme somme, un tableau étant associé à chaque diagramme d'antenne, une entrée étant le gisement en fonction de l'axe du lobe principal de l'antenne et une entrée étant l'élévation de la cible en fonction de l'horizontalité de l'antenne. Pour chaque cellule (gisement, élévation) de chaque diagramme la puissance relative la plus probable est établie par des méthodes du type moyenne, histogramme ou autres.

Le nombre de tours donné est par exemple défini pour laisser apparaître des dégradations en cours desdits diagrammes.
L'antenne peut aussi bien être destinée à des applications ATC qu'à des applications IFF. Elle comporte par exemple au moins deux diagrammes d'antenne.
Elle peut être fixe ou tournante. Elle peut également être à balayage électronique.

Avantageusement, la mesure desdits diagrammes est utilisée pour vérifier le niveau de dégradation desdits diagrammes.

L'invention a également pour objet un radar secondaire mettant en œuvre un tel procédé.

D'autres caractéristiques et avantages de l'invention apparaîtront à l'aide de la description qui suit, faite en regard de dessins annexés qui représentent :
- la figure 1, un exemple de synoptique d'un radar secondaire Mode S ;
- la figure 2, une illustration de la mise en œuvre matérielle du procédé selon l'invention sur le radar de la figure 1 ;
- les figures 3a à 3f, une présentation, à titre d'exemple, d'un échantillonnage de diagrammes d'antenne par les Fruits de trois cibles ;
- les figures 4a et 4b, une illustration des diagrammes d'antenne mesurables par le procédé selon l'invention, pour une antenne de type LVA typiquement dans le domaine ATC, respectivement pour des fréquences à 1030 MHz (émission) et à 1090 MHz (réception) ;
- les figures 5a et 5b, une illustration des diagrammes d'antenne mesurables par le procédé selon l'invention, relatifs à une antenne poutre de plus petite dimension typiquement pour une application IFF, respectivement pour des fréquences à 1030 MHz (émission) et à 1090 MHz (réception).

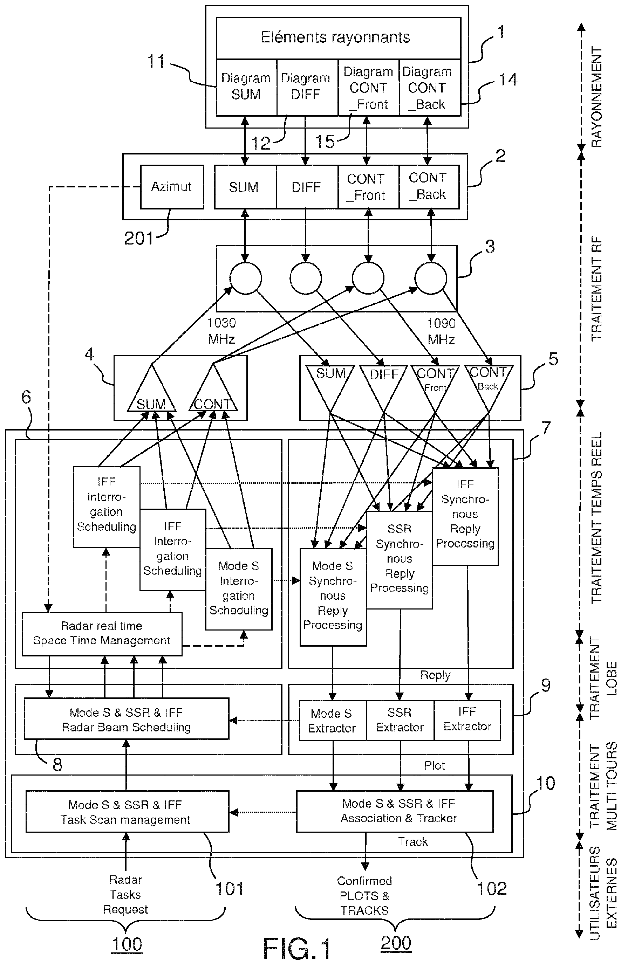

En regard de la figure 1 qui représente un exemple de synoptique d'un radar Mode S, on rappelle les principes d'un tel radar.
Le principe du radar secondaire mode S (défini en détail par l'ICAO Annexe 10 vol.4) consiste à :
- émettre des interrogations sélectives :
   - soit indiquant le destinataire : une seule cible désignée par son adresse Mode S ;
   - soit indiquant l'identifiant de l'émetteur ;
- recevoir des réponses sélectives :
   - soit indiquant l'identifiant de l'émetteur : la même adresse Mode S de la cible ;
   - soit indiquant le destinataire : l'identifiant de l'interrogateur.

Dans son emploi usuel, le radar secondaire fonctionne en mode synchrone, c'est-à-dire qu'il émet une interrogation et attend une réponse en cohérence avec celle-ci, ce qui lui permet de localiser par mesure (en azimut et distance) et d'identifier (par l'adresse mode S) la cible.
Pour effectuer cette tâche avec performance, le radar est équipé d'une antenne 1 ayant plusieurs diagrammes 11, 12, 14, 15 dont les rôles sont classiquement :
- un diagramme somme 11, noté par la suite SUM, pour interroger et détecter la réponse synchrone de la cible ;
- un diagramme différence 12, noté DIFF, pour localiser finement la cible dans le faisceau SUM ;
- un premier diagramme de contrôle 15, noté CONT_front, pour bloquer et réjecter les réponses issues de cibles face à l'antenne non présentes dans le faisceau de SUM ;
- un deuxième diagramme de contrôle 14, noté CONT_back, pour bloquer et réjecter les réponses issues de cibles au dos à l'antenne (donc forcément non présentes dans le faisceau de SUM).
Selon les missions et donc les performances attendues du radar les antennes peuvent être :
- de plusieurs diagrammes :
   - 4 diagrammes : SUM, DIFF, CONT_Front & CONT_Back ;
   - 3 diagrammes : SUM, DIFF, CONT (CONT_Front et CONT_Back sont regroupés au niveau de l'antenne) ;
   - 2 diagrammes : SUM, DIFF/CONT (DIFF, CONT_Front & CONT_Back sont regroupés au niveau de l'antenne).
- de dimensions différentes :
   - en largeur :
      o ayant une grande largeur pour avoir un faisceau principal fin apportant un fort gain ainsi que pour être sélective et précise en azimut ;
   - en hauteur :
      ∘ ayant une grande hauteur, de type Large Vertical Aperture (LVA) apportant du gain et une protection contre les réflexions sol (principalement en ATC) ;
      ∘ ayant une petite hauteur, de type « poutre » apportant une mobilité (principalement en IFF).

Alors que les diagrammes SUM et DIFF sont classiquement fins avec des lobes à 3 dB entre 2,4° à 10°, les diagrammes CONT_Front et CONT_Back cherchent à couvrir pratiquement 180° chacun.

Les antennes peuvent aussi être :
- de diagramme fixe, dites « mécanique » et tournante ;
- de diagramme évolutif, à balayage électronique, dites « AESA » fixe ou tournante.

Dans son utilisation opérationnelle, le radar reçoit des réponses non sollicitées (sans interrogation associée de sa part), celles-ci sont nommées « False Reply Unsynchronized in Time » ou Fruit. Elles sont ainsi nommées car :
- elles ne sont pas attendues par le radar qui les rejette (« False ») ;
- elles sont des réponses très similaires à celles synchrones et issues des mêmes cibles dans la même couverture du radar, ayant même fréquence et même format de message (« Reply ») ;
- elles ne sont pas associées à une interrogation de ce radar, mais à celle d'un autre radar ou même émise par la cible de façon périodique telles que les squitters ADS-B_out (« Unsynchronized in Time »)

De par leur caractéristique asynchrone les Fruits sont reçus par le radar sur tous ses diagrammes d'antenne.
Enfin, les Fruits Mode S sont tous identifiables par l'unique adresse Mode S associée à chaque cible.
Alors que les Fruits générés par un radar secondaire sont actuellement traités comme des défauts qui doivent être filtrés avant traitement, l'invention exploite avantageusement ces Fruits au cours du traitement pour mesurer les diagrammes d'antenne.

Comme cela sera décrit par la suite, le principe de l'invention consiste donc à exploiter les Fruits Mode S pour mesurer en permanence les diagrammes des antennes de radars secondaires. Cet emploi des Fruits pour mesurer les diagrammes d'antenne en continu est une exploitation opportuniste et judicieuse de la présence d'avions et dans une moindre mesure d'interrogateurs dans l'environnement de détection.
Avantageusement, cette exploitation est sans aucune influence sur le fonctionnement opérationnel des radars, et cela quel que soit le type des antennes décrites ci-avant. Elle ne nécessite aucune transmission RF supplémentaire à la tâche opérationnelle du radar elle ne pollue donc pas l'environnement RF 1030/1090 MHz.

Avant de décrire plus en détail l'invention, on décrit les éléments constitutifs du radar Mode S de la figure 1. Le synoptique fait apparaître le fonctionnement synchrone du radar Mode S :
- sur la partie gauche 100 par la génération des interrogations ;
- sur la partie droite 200 par le traitement synchrone des réponses associées,
ainsi que les synchronisations entre celles-ci par les flèches transverses entre gauche et droite.

Les fonctions des principaux éléments sont rappelées ci-après :
L'antenne 1 assure le rayonnement des interrogations à 1030 MHz et des réponses en retour à 1090 MHz, selon les quatre diagrammes : SUM, DIFF, CONT_Front et CONT_Back, ou selon deux diagrammes (SUM, DIFF/CONT) ou trois diagrammes (SUM, DIFF, CONT).

Un joint tournant 2 et des câbles de descente d'antenne assurent :
- couplage RF des signaux transmis à 1030 MHz et reçus à 1090 MHz indépendamment pour les quatre diagrammes entre la partie tournante et la partie fixe du radar ;
- la diffusion de la position en azimut 201 de l'axe du lobe principal de l'antenne.

Un traitement RF comporte :
- un duplexeur ou circulateur 3 assurant le couplage RF entre les signaux transmis à 1030 MHz et reçus à 1090 MHz indépendamment pour les quatre diagrammes ;
- un émetteur 4 assurant :
   - la transmission des interrogations à 1030 MHz sur le diagramme SUM ;
   - le blocage des transpondeurs en dehors du lobe SUM à 1030 MHz par les diagrammes CONT_Front et CONT_Back ;
   - ceci pour les différents protocoles secondaires : IFF, SSR et Mode S ;
- un récepteur 5 assurant la réception des réponses à 1090 MHz sur les quatre diagrammes SUM, DIFF, CONT_Front et CONT_Back, pour les différents protocoles secondaires : IFF, SSR et Mode S.

Un traitement temps réel comporte :
- une gestion spatio-temporelle 6 assurant la gestion temps réel des périodes d'interrogations et d'écoutes associées pour les différents protocoles secondaires : IFF, SSR et Mode S ;
- un traitement du signal 7 assurant :
   - le traitement des réponses dans les périodes d'écoutes associées aux interrogations pour les différents protocoles secondaires : IFF, SSR et Mode S ;
   - la détection et le décodage des réponses Synchrones dans le lobe principal de l'antenne en exploitant les quatre diagrammes :
      ∘ SUM : pour détecter les réponses reçues dans le lobe principal ;
      ∘ DIFF : pour localiser finement en azimut les réponses reçues dans le lobe principal SUM et éventuellement pour la détection ;
      ∘ CONT_Front et CONT_Back : pour réjecter les réponses reçues sur les lobes secondaires de SUM et DIFF dans le cas d'une détection dans le lobe principal de DIFF.

Un traitement dans le lobe principal de l'antenne comporte :
- une gestion 8 des cibles présentes dans le lobe, assurant :
   ∘ la préparation des transactions (interrogations et réponses) à effectuer dans le prochain lobe pour les différents protocoles secondaires IFF, SSR et Mode S ;
   ∘ le placement des interrogations et réponses Mode S dans la future période « Roll call » en fonction de l'état des transactions venant d'être effectuées.
- des extracteurs 9 assurant la constitution de plots pour chacun des différents protocoles secondaires IFF, SSR et Mode S, à partir des réponses synchrones reçues dans le lobe.

Un traitement multi tours 10 comporte :
- une gestion 101 des tâches Mode S à effectuer avec les cibles dans la couverture, assurant la prédiction de positions des cibles (rendez-vous d'antenne) et la préparation des tâches à effectuer avec ces positions selon les demandes externes et l'état des transactions des tours précédents ;
- une association des plots et un pistage 102 des cibles dans la couverture assurant le pistage des cibles pour améliorer les performances (élimination des faux plots, contrôle de données décodées notamment) et pour prédire la position future de celles-ci.

Une interface avec les utilisateurs permet la prise en compte par le radar de différentes requêtes et de visualiser les plots et les poursuites de cibles.

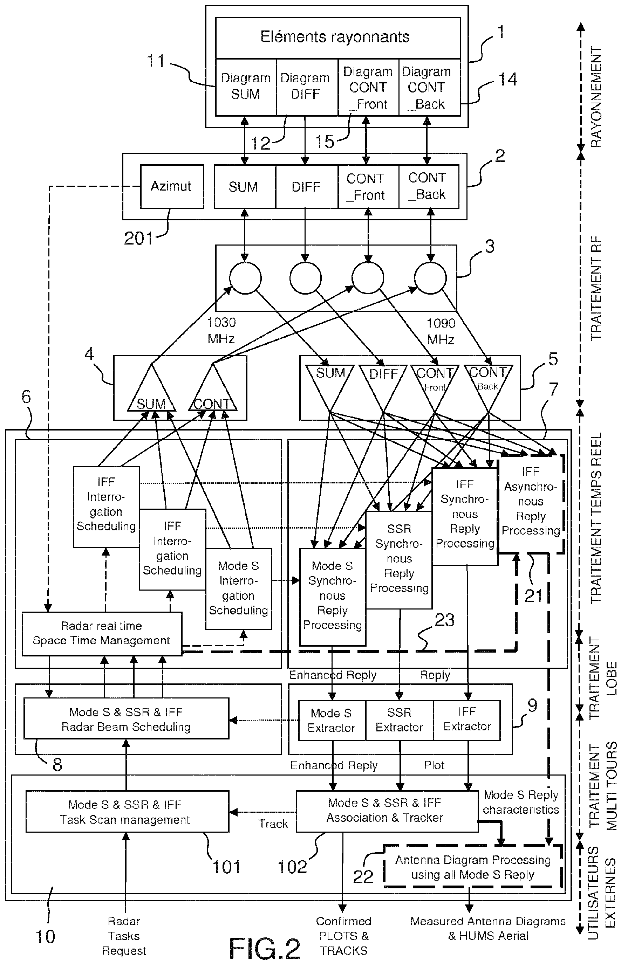

La figure 2 illustre la mise en œuvre matérielle de l'invention en présentant le synoptique du radar de la figure 1 augmenté des éléments propres à l'invention. Les principaux éléments de l'invention appliqués au radar Mode S sont représentés en traits gras discontinus sur la figure 2.
Alors que le fonctionnement d'un radar Mode S est synchrone, on voit que les traitements ajoutés 21, 22 ne sont pas liés à l'émission et n'exploitent que la position en azimut de l'axe du lobe principal de l'antenne 23.
La plupart des éléments restent inchangés, vérifiant en cela notamment la non intrusion de l'invention dans le fonctionnement opérationnel du radar Mode S.

Un premier traitement ajouté 21 est un traitement permanent des réponses asynchrones en Mode S (indépendamment des périodes d'écoutes associées aux interrogations), ce traitement 21 assure la détection et le décodage des réponses asynchrones en exploitant séparément mais également les quatre diagrammes d'antenne : SUM, DIFF, CONT_Front et CONT_Back pour :
- détecter toutes les réponses reçues, asynchrones et synchrones ;
- décoder les réponses non emmêlées pour en extraire l'adresse Mode S,
- pour enrichir chaque réponse décodée de ses caractéristiques, notamment l'heure de détection, l'azimut du lobe principal de l'antenne lors de la détection, la puissance reçue dans les diagrammes SUM, DIFF, CONT_Front et CONT_Back.

A cet effet, la gestion spatio-temporelle 6 transmet la position en azimut 23 du lobe principal de l'antenne au traitement permanent 21 des réponses asynchrones Mode S.
On obtient en parallèle, avantageusement, un enrichissement des réponses synchrones par les puissances mesurées sur les diagrammes SUM, DIFF, CONT_Front et CONT_Back.
Au niveau des extracteurs 9, on obtient également un enrichissement des plots Mode S de leurs réponses synchrones avec pour chaque réponse la puissance mesurée sur SUM, DIFF, CONT_Front et CONT_Back et l'azimut d'antenne.

Un deuxième élément ajouté 22 est un traitement des diagrammes d'antenne qui assure le calcul des diagrammes d'antenne en élévation à partir des réponses synchrones (de tous les modes) et asynchrones Mode S. Ce deuxième traitement est ajouté dans le traitement multi-tours où l'association des plots et un pistage 102 des cibles transmet les pistes avec l'adresse Mode S, heure et position complétées par les réponses enrichies de la puissance mesurée sur SUM, DIFF, CONT_Front et CONT_Back et l'azimut d'antenne.

Un radar secondaire, par exemple équipé de ces éléments complémentaires, est apte à mettre en œuvre le procédé selon l'invention. Celui-ci utilise astucieusement les réponses Mode S synchrones et asynchrones (notamment les Fruits incluant les squitters ADS-B) pour échantillonner les diagrammes de l'antenne du radar à tous les gisements de celle-ci. Bien sûr, le principe d'emploi de Fruits pour mesurer les diagrammes d'antenne n'est possible qu'en présence d'avions, et en moindre mesure d'interrogateurs, dans l'espace environnant, ce qui est le cas en pratique.

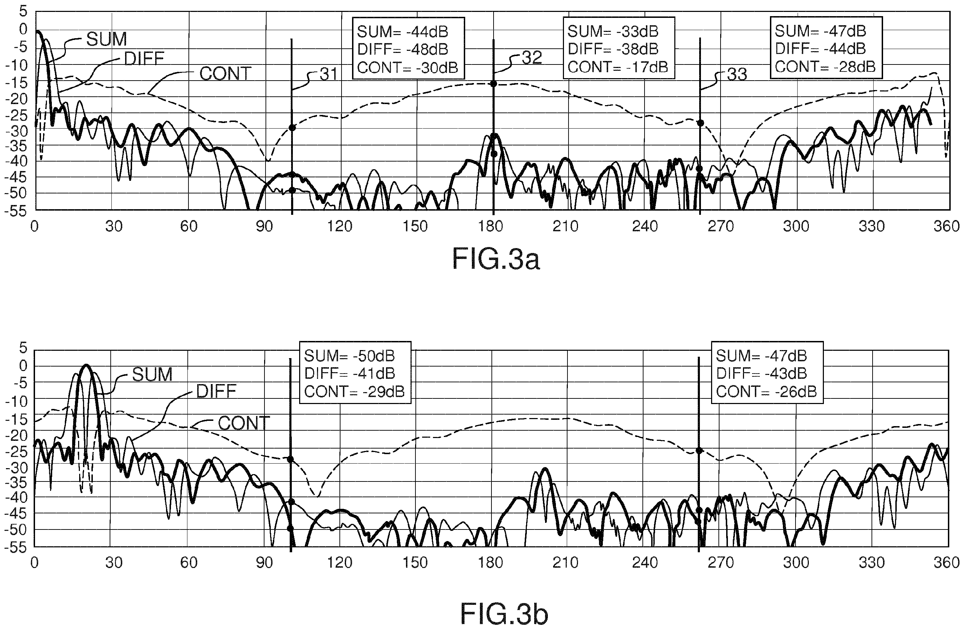

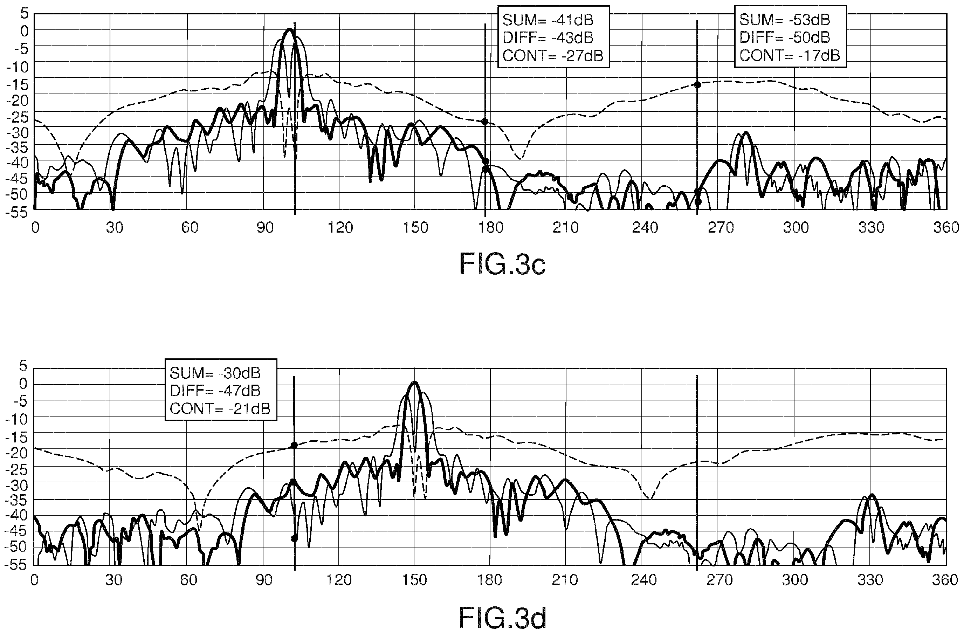

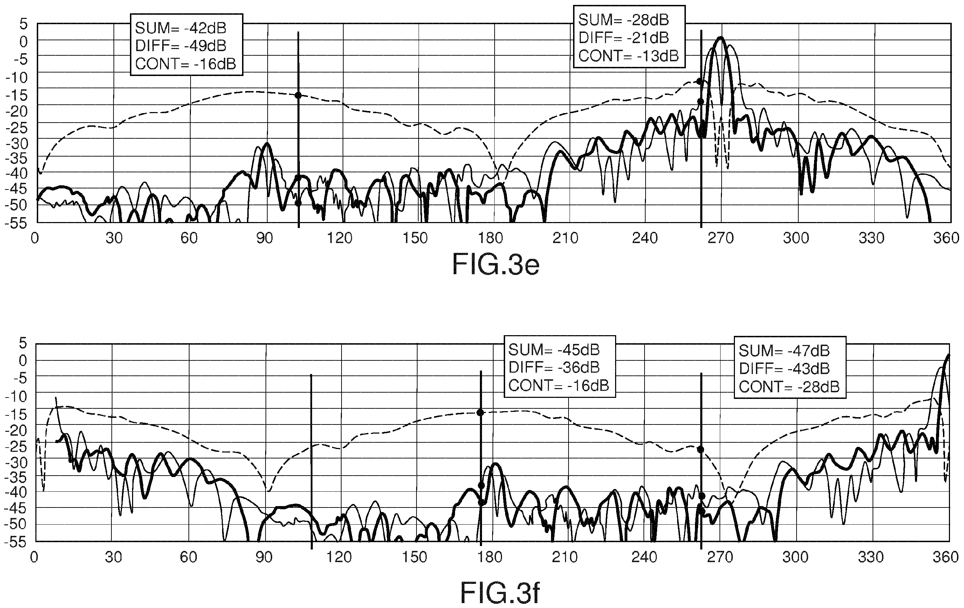

Les figures 3a à 3f présentent, à titre d'exemple, un échantillonnage des diagrammes d'antennes par les Fruits de trois cibles 31, 32, 33. Les diagrammes d'antenne sont représentés dans un système d'axes où les abscisses représentent les azimuts et où les ordonnées représentent les gains de l'antenne rotative selon ses différentes positions en azimut lors de sa rotation.

Les figures 3a à 3f illustrent le principe de l'invention décrit précédemment. Etant reçus à tout moment, les Fruits échantillonnent les diagrammes d'antenne à différents gisements de l'antenne. L'invention exploite avantageusement cette propriété.
Plus particulièrement, les figures 3a à 3f présentent les trois diagrammes sommes SUM, différence DIFF et de contrôle CONT à un tour d'antenne donné (tour d'antenne N) aux différents azimuts lors de la réception de Fruit, respectivement 0°, 20°, 100°, 150°, 270°, et 360°, l'azimut 0° indiquant la direction du nord.
Les trois cibles 31, 32, 33 situées à différents azimuts génèrent quelques Fruits lors de ce tour N :
- La première cible 31 est à l'Est à l'azimut 100°, en léger déplacement en azimut croissant ;
- La deuxième cible 32 est au Sud, à l'azimut 180° en léger déplacement en azimut décroissant ;
- La troisième cible 33 est à l'Ouest, à l'azimut 260° en azimut constant.
Pour simplifier, dans cet exemple les Fruits issus des cibles sont considérés détectés à la même heure, donc pour exactement le même azimut d'antenne mais bien sûr à des gisements différents de l'antenne.

A chaque détection d'un Fruit, l'invention associe à la fois son dépointage en gisement et le niveau relatif de puissance reçu sur chacun des diagrammes. Le tableau 1 ci-dessous indique, en regard de l'exemple des figures 3a à 3f, les valeurs échantillonnées des diagrammes d'antenne par les Fruits des trois cibles.

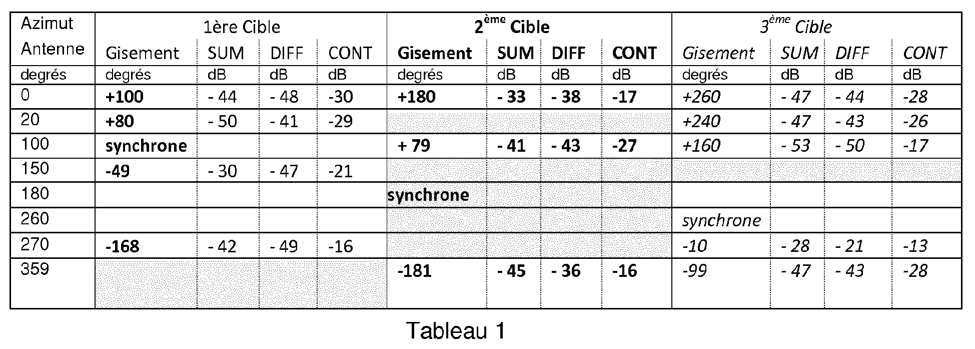

A la fin du tour N, ces valeurs sont accumulées aux valeurs acquises lors des tours d'antenne précédents, en fonction du gisement, tel que présenté dans le tableau 2 ci-dessous, quelle que soit la cible ayant généré les Fruits (ou en sélectionnant certaines cibles selon des critères de puissance, d'azimut, ...). Dans ce tableau, les valeurs « après » le tour N n'existent pas encore (pour le tour N+1). Les valeurs « avant » le tour N sont différentes pour chaque gisement, ce qui est exprimé par les notations Xx, Yy et Zz. Dans ce tableau 2, les mesures issues de la première cible sont en caractères normaux, les mesures issues de la deuxième cible sont en caractère gras et les mesures issues de la troisième cible sont en caractères italiques.

**Tableau 2**

| Gisement | SUM | | | DIFF | | | CONT | | |
|---|---|---|---|---|---|---|---|---|---|
| scan | avant | N | après | avant | N | après | avant | N | après |
| -168 | Xx1 | -42 | | Xx2 | -49 | | Xx3 | -16 | |
| +240/-120 | Yy1 | -47 | | Yy2 | -43 | | Yy3 | -26 | |
| +260/-100 | *Zz1* | -47 | | *Zz2* | *-44* | | *Zz3* | -28 | |
| -99 | *Tt1* | -47 | | *Tt2* | *-43* | | *Tt3* | -28 | |
| -50 | Uu1 | -30 | | Uu2 | -47 | | Uu3 | -21 | |
| -10 | Vv1 | -28 | | Vv2 | -21 | | Vv3 | -13 | |

| Faisceau principal | Synch | **Synch** | | Synch | **Synch** | | Synch | **Synch** | |
|---|---|---|---|---|---|---|---|---|---|
| +79 | **Aa1** | **-41** | | **Aa2** | **-43** | | **Aa3** | **-27** | |
| + 80 | Bb1 | -50 | | Bb2 | -41 | | Bb3 | -29 | |
| +100 | Cc1 | -44 | | Cc2 | -48 | | Cc3 | -30 | |
| +160 | *Dd1* | *-5*3 | | *Dd2* | *-50* | | *Dd3* | *-17* | |
| -181/+179 | **Ee1** | **-43** | | **Ee2** | **-36** | | **Ee3** | **-16** | |
| +180 | **Ff1** | **-33** | | **Ff2** | **-38** | | **Ff3** | **-17** | |

Ce principe appliqué sur un grand nombre de tours dans un environnement riche en cibles et en Fruits permet d'établir pour chaque gisement de chaque diagramme SUM, DIFF, CONT de l'antenne une moyenne (ou un histogramme) sur un grand nombre de mesures (accumulation de mesures), assurant une bonne précision des diagrammes d'antenne sur le site radar considéré. Le grand nombre de tours évoqué ci-dessus est par exemple obtenu sur une journée de fonctionnement voire une semaine ou plus selon la précision attendue des diagrammes et la densité de Fruits du site.
Dans le cas d'une antenne de type LVA, cette même approche peut être menée par tranches d'élévation des cibles quand l'altitude de la cible est connue via l'altitude barométrique transmises dans les réponses synchrones.

Les mesures des différents diagrammes SUM, CONT et DIFF de l'antenne par tranches d'élévation peut ainsi être effectuée quotidiennement (la base de temps étant par exemple 24 heures) et diffusées à des services de maintenance sur ce rythme.
Avantageusement, le suivi des diagrammes d'antenne mesurés de jour en jour (voire en base semaine considérant que la dégradation possible est par nature lente) selon ce principe de mesure, permet de détecter une dégradation progressive éventuelle de ces diagrammes, en particulier des déformations de diagramme en élévation. Cette déformation des diagrammes peut permettre de localiser des éléments rayonnants défaillants. Une analyse permanente de cette déformation permet d'alerter automatiquement afin de prévoir si nécessaire une opération de réparation à programmer avant que les performances du radar se dégradent, dans une approche de type HUMS (« Health and Usage Monitoring System »).
L'exemple décrit en regard des figures 3a à 3f traite trois diagrammes d'antenne, SUM, DIFF et CONT. Le même principe s'applique pour les quatre diagrammes d'antenne SUM, DIFF, CONT_Front et CONT_Back, tout comme les deux diagrammes SUM, DIFF/CONT.

Le décodage des réponses asynchrones, correspondant aux Fruits, est effectué comme le décodage des réponses synchrones d'un radar classique, de façon connue de l'homme du métier.
La détection des réponses par un radar selon l'invention diffère selon que ces réponses sont synchrones ou asynchrones comme le résume le tableau 3 ci-dessous.

**Tableau 3**

| | *Radar classique* | *Radar selon l'invention* | |
|---|---|---|---|
| **Diagrammes Antenne** | **Réponse Synchrone** | **Réponse Synchrone** | **Réponse Asynchrone** |
| | que dans fenêtres d'écoute | que dans fenêtres d'écoute | en permanence |
| SUM | Détecte et décode | Détecte et décode Si besoin enrichie de la puissance P_{SUM} | Détecte et décode enrichie de la puissance P_{SUM} |
| DIFF | Localise dans lobe SUM (Détecte et décode) | Localise dans lobe SUM (Détecte et décode) Enrichie de la puissance P_{DIFF} | Détecte et décode Enrichie de la puissance P_{DIFF} |
| CONT_Front | Réjecte si P_{SUM} < P_{CONT_Front} +paramètre | Enrichie de la puissance P_{CONT_Front} | Détecte et décode Enrichie de la puissance P_{CONT_Front} |
| CONT_Back | Réjecte si P_{SUM} < P_{CONT_Back} +paramètre | Enrichie de la puissance P_{CONT_Back} | Détecte et décode Enrichie de la puissance P_{CONT_Back} |

Toutes les réponses, synchrones ou asynchrones, sont enrichies de la puissance mesurée selon chaque diagramme et ce quelque soit le diagramme ayant servi à la détecter et décoder.

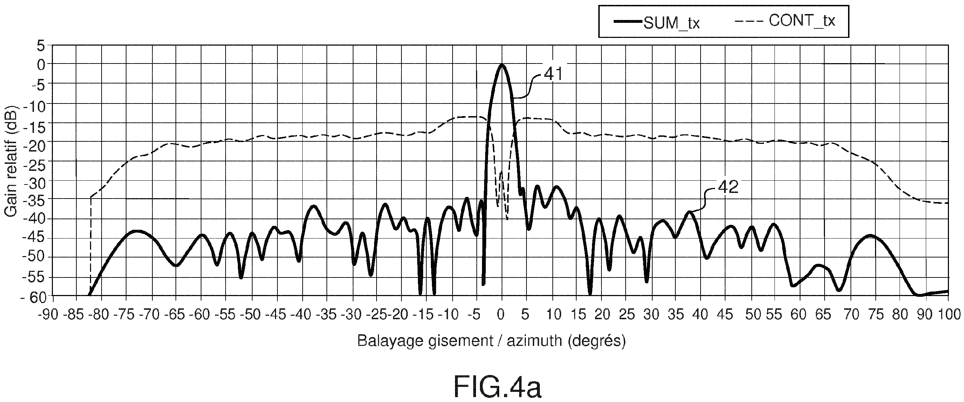

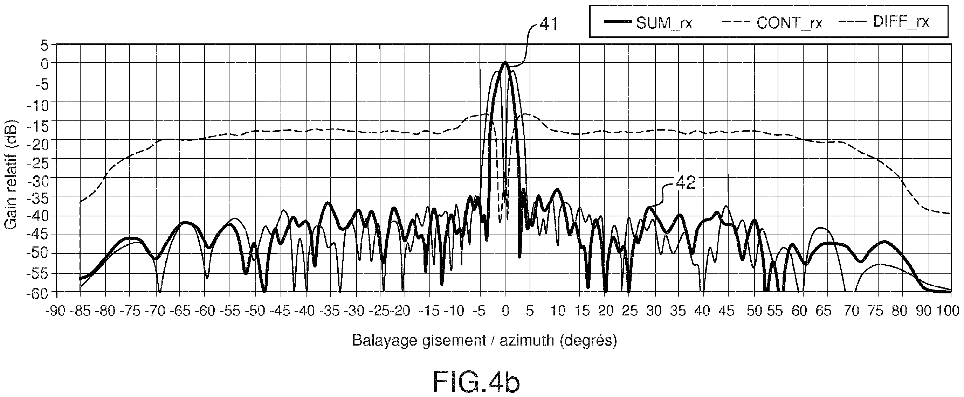

Les figures 4a et 4b illustrent des diagrammes d'antennes mesurables par le procédé selon l'invention, pour une antenne de type LVA dans le domaine ATC, respectivement pour des fréquences à 1030 MHz (émission) et à 1090 MHz (réception).
La corrélation des informations d'amplitude des trois diagrammes d'antenne SUM, DIFF, CONT, associées aux détections des réponses synchrones et asynchrones Mode S permet de construire ces diagrammes par tranche d'élévation. Par ailleurs, comme les mêmes éléments rayonnants de l'antenne sont utilisés en émission et en réception, cette analyse passive en réception permet de valider aussi les diagrammes en émission (comme le montre la forte similitude entre les diagrammes émission et réception). Ceci peut avantageusement être effectué tout au long de l'exploitation opérationnelle du radar sans influer sur son fonctionnement et sans outillage externe.

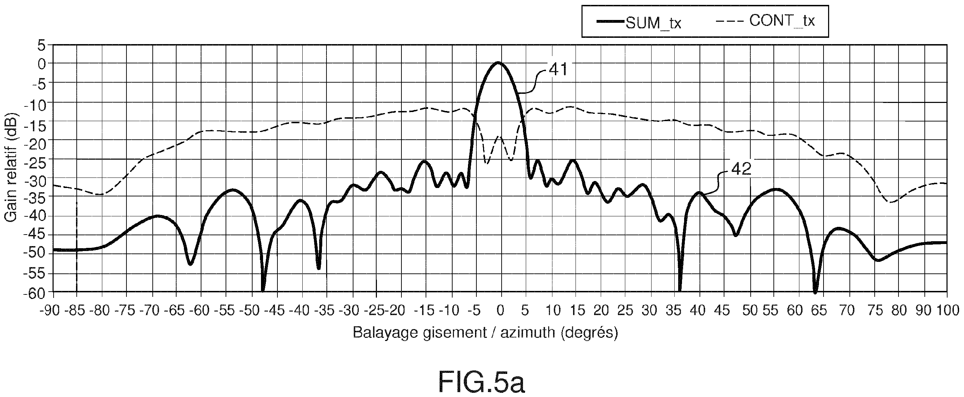

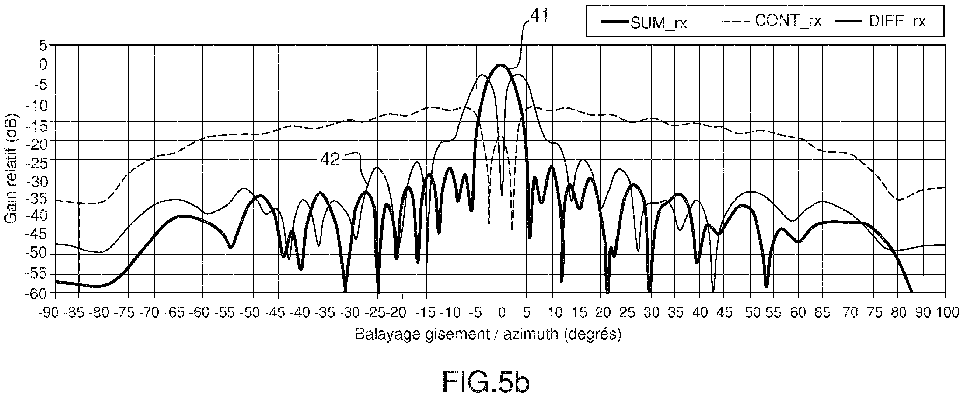

Les figures 5a et 5b présentent des diagrammes d'antenne mesurables par le procédé selon l'invention, relatifs à une antenne poutre de plus petite dimension pour une application IFF, respectivement pour des fréquences à 1030 MHz (émission) et à 1090 MHz (réception). A nouveau la similitude entre les diagrammes émission et réception s'avère importante.
Donc, pour l'application ATC comme pour l'application IFF, la similitude entre les diagrammes à 1030 MHz (émission) et à 1090 MHz (réception) confirme que le traitement des Fruits en réception permet de détecter des dégradations en émission comme en réception sur une période donnée, journalière par exemple, comme le propose l'invention.
Par ailleurs, la crête des lobes secondaires 42 des diagrammes SUM et DIFF étant de l'ordre de -25 dB à -35 dB en relatif au gain maximal obtenu par le faisceau principal 41 de l'antenne, l'invention propose de n'utiliser que les cibles proches dont le niveau de puissance reçue est d'au moins 30dB au-dessus du seuil de détection et de décodage des réponses. Cela permet de représenter le maximum des lobes secondaires des diagrammes SUM et DIFF, ce qui conduit à n'utiliser que les Fruits dont la cible est dans un rayon de 50 Nm autour du radar (valeur typique ajustable par paramètre par l'opérateur).
Les tracés de diagrammes d'antenne d'acceptation en usine sont faits par exemple avec un pas de gisement inférieur à 0,1°. En conséquence de cette précision, on peut conclure, pour le pas de mesure des diagrammes d'antenne selon l'invention dans une approche HUMS, les points suivants :
- Etant donné que les remontées de lobes secondaires s'effectuent naturellement sur plusieurs degrés, une précision de l'ordre de 1° peut suffire en dehors du lobe principal ;
- On peut garder une meilleure précision dans le lobe principal, de l'ordre de 0,1°.
Ces précisions de pas d'analyse des diagrammes sont données à titre indicatif. Ils peuvent être paramétrés par un opérateur en fonction de ses besoins de précision, et du taux de Fruits disponibles d'avions proches du radar notamment.

Les réponses synchrones comme les réponses asynchrones utilisées par un radar selon l'invention comportent des caractéristiques communes, notamment en ce qui concerne l'heure de détection, l'adresse Mode S, l'azimut antenne et les puissances reçues sur les différents diagrammes SUM, DIFF, CONT_Front et CONT_BACK. Les détections synchrones du radar ont classiquement lieu au rythme de la rotation de l'antenne, typiquement entre 4 secondes et 12 secondes. En règle générale, le taux de Fruits en Europe est estimé à plusieurs milliers par seconde, ce qui conduit à estimer une détection de l'ordre de 5 000 à 10 000 Fruits par tour d'antenne. Cela permet avantageusement un bon échantillonnage en gisement suite à l'aspect asynchrone des Fruits vis-à-vis de la rotation de l'antenne. En revanche, l'échantillonnage en élévation dépend directement de la distribution en distance et altitude des cibles qui évolue naturellement assez lentement au cours du vol des cibles, nécessitant en conséquence une durée relativement longue pour établir les diagrammes d'antenne pour différentes tranches d'élévation.
En ce qui concerne les réponses synchrones acquises à chaque tour dans le lobe principal, dans un radar classique l'extracteur constituant le plot associe ces réponses pour constituer les caractéristiques du plot et pour certains radars en particulier pour définir la puissance maximale reçue sur le nez du diagramme SUM à partir du dépointage de la réponse synchrone par rapport à l'axe de l'antenne (OBA) et de la puissance mesurée de la réponse.
Dans la présente invention, on calcule pour chaque réponse asynchrone :
- son gisement antenne : par extrapolation de la position synchrone de la cible en azimut à l'heure de détection du Fruit et de la position de l'antenne en azimut à l'heure de détection du Fruit ;
- sa puissance relative (faite par rapport au maximum de la voie somme pour les quatre diagrammes) : par extrapolation de la puissance synchrone sur le diagramme SUM de la cible encadrant temporellement l'heure de détection du Fruit à l'heure du Fruit et de la puissance reçue du Fruit selon chacun des différents diagrammes ;
- son élévation : par extrapolation de l'élévation synchrone de la cible encadrant temporellement l'heure de détection du Fruit à l'heure du Fruit.

Ainsi, avec les puissances des réponses synchrones, reçues par le faisceau principal 41 de la voie somme (SUM) de l'antenne, encadrant temporellement le Fruit, on estime à l'heure du Fruit la puissance de la cible si elle avait été dans le faisceau principal et par différence avec la puissance du Fruit sur chaque diagramme on obtient la puissance relative entre le faisceau principal de l'antenne du diagramme SUM (gain maximal) et les lobes secondaires au gisement du Fruit pour les quatre diagrammes

Selon l'invention, pour chaque Fruit F_{N,i} et pour chaque réponse synchrone on accumule les données ci-dessous (données à titre d'exemple) dans un tableau à deux entrées associé à chaque diagramme antenne SUM, DIFF, CONT_Front et CONT_Back :
- en gisement :
   - de -180° à - azimut à -3dB du lobe principal [typique en ATC à - 2,4°] au pas de 1°
   - de +180° à + azimut à -3dB du lobe principal [typique en ATC à +2,4°] au pas de 1°
   - de (- azimut à -3dB) à (+ azimut à -3dB du lobe principal) [typique en ATC de -2,4° à +2,4°] au pas de 0,1°
- en élévation :
   - de 0° à 20° au pas de 1°
- aux valeurs du Fruit F_{N,i} :
   - gisement antenne lors du Fruit N,i
   - élévation cible lors du Fruit N,i
- les valeurs de puissance relative des diagrammes d'antenne :
   - Puissance SUM relative lors du Fruit N,i
   - Puissance DIFF relative lors du Fruit N,i
   - Puissance CONT_Front relative lors du Fruit N,i
   - Puissance CONT_Back relative lors du Fruit N,i

Sur une période très lente, typiquement la journée, voire plus selon la précision voulue par l'opérateur dans la mesure des diagrammes, on calcule :
- pour chaque diagramme antenne SUM, DIFF , CONT_Front et CONT_Back ;
- pour chaque tranche d'élévation;
- pour chaque tranche de gisement ;
la moyenne des puissances relatives accumulées dans chaque cellule.

En cas de besoin, on effectue le lissage à l'intérieur de chaque diagramme antenne SUM, DIFF, CONT_Front et CONT_Back en considérant la quantité et la qualité des Fruits utilisés pour mesurer chaque cellule des diagrammes.

Selon l'invention, on établit par exemple un gabarit des différents diagrammes d'antenne SUM, DIFF, CONT_Front et CONT_Back en fonction des tracés usine de l'antenne (lors de l'acceptation usine) équipant le site radar.
Suite au calcul des diagrammes d'antenne au moyen des Fruits, typiquement chaque jour, l'invention compare les mesures effectuées aux gabarits en élévation et produit une synthèse des points hors du gabarit pondérant par exemple celle-ci en considérant la quantité et la qualité des Fruits utilisés pour mesurer les diagrammes.
Cette synthèse HUMS, par exemple journalière, permet d'évaluer une potentielle dégradation en cours des diagrammes d'antenne.
De plus, en ayant établi préalablement la déformation caractéristique des diagrammes d'antenne en fonction de différents types de dégradation de partie spécifique de l'aérien, l'invention propose par exemple les éléments dégradés suivant :
- perte de niveau uniforme des diagrammes SUM, DIFF, CONT_Front ou CONT_Back en gisement et élévation ;
   - pouvant signifier une dégradation du Joint Tournant de SUM, DIFF, CONT_Front ou CONT_Back ;
   - pouvant signifier une augmentation des pertes des câbles RF de SUM, DIFF, CONT_Front ou CONT_Back ;
- remontée des lobes secondaires de diagramme SUM, DIFF, CONT_Front ou CONT_Back à certains gisements quelle que soit l'élévation
   - pouvant signifier une dégradation d'une colonne de rayonnement.

D'autres éléments dégradés peuvent de même être mis en évidence.
Cette analyse permanente des quatre diagrammes d'antenne effectuée en regard de plusieurs gabarits permet de quantifier au niveau fonctionnel une dégradation des performances pouvant à terme déclarer le radar ou le récepteur ADS-B utilisant le même aérien comme dégradé voire en panne.

Au-delà des gabarits usuels pour garantir la performance, des gabarits dédiés peuvent être définis dans le but de détecter des dégradations usuelles de l'aérien auxquelles auront été associées les déformations des diagrammes d'antenne consécutifs à ces dégradations. Ceci permettant alors la pré-localisation de l'élément défaillant de l'antenne et d'en planifier le remplacement avant que le radar ne devienne non opérationnel. Avantageusement, le procédé selon l'invention est mis en œuvre pendant les phases opérationnelles, sans générer de transmission dédiée, de manière permanente et sans interférer avec le fonctionnement du radar.

## Revendications

1. Procédé de mesure des diagrammes d'antenne (1) en gisement d'un radar secondaire par tranche d'élévation, chaque diagramme (11, 12, 14, 15) étant associé à une voie de réception (5), **caractérisé en ce qu'**il utilise les réponses synchrones et les réponses asynchrones, non sollicitées de type Fruit, émises par des cibles présentes dans l'environnement aérien dudit radar et détectées sur un nombre de tours d'antenne donné, à chaque détection d'une réponse, l'heure de ladite détection, la valeur de l'azimut du faisceau principal (41) de l'antenne et la valeur de puissance reçue sur chacune desdites voies étant associées à ladite détection (21), chaque réponse asynchrone étant enrichie de son gisement, de sa puissance relative par diagramme et de son élévation par différence avec les mêmes valeurs extrapolées de ladite réponse synchrone à l'heure du Fruit, lesdites valeurs obtenues sur le nombre de tours donné étant mémorisées, les diagrammes mesurés étant échantillonnés à partir desdites valeurs mémorisées (22),
pour chaque réponse asynchrone d'une cible, les données suivantes étant calculées :
- son gisement antenne : par extrapolation de la position synchrone de ladite cible en azimut à l'heure de détection du Fruit et de la position de l'antenne en azimut à l'heure de détection du Fruit ;
- sa puissance relative : par extrapolation de la puissance desdites réponses synchrones, acquises avec le faisceau principal (41) de la voie somme de l'antenne, de ladite cible encadrant temporellement l'heure de détection du Fruit à l'heure du Fruit et de la puissance du Fruit sur chacun des diagrammes de l'antenne ;
- son élévation : par extrapolation de l'élévation, reçue dans les réponses synchrones, de ladite cible encadrant temporellement l'heure de détection du Fruit à l'heure du Fruit.

2. Procédé selon la revendication 1, **caractérisé en ce que** ladite antenne comporte un des ensembles de diagrammes suivant :
- un diagramme somme (SUM), un diagramme différence (DIFF), un diagramme de contrôle pour rejeter des réponses de cibles face à l'antenne (CONT_Front) et un diagramme de contrôle pour rejeter des cibles à l'arrière de l'antenne (CONT_Back) ;
- un diagramme somme (SUM), un diagramme différence (DIFF), un diagramme de contrôle (CONT);
- un diagramme somme (SUM) et un diagramme différence et contrôle(DIFF/CONT).

3. Procédé selon l'une quelconque des revendications précédentes, **caractérisé en ce que** les réponses de type Fruit et les réponses synchrones sont enrichies par des caractéristiques représentatives de l'acquisition desdites réponses, lesdites caractéristiques étant pour chaque réponse au moins l'une des caractéristiques suivantes :
- puissance reçue selon chaque diagramme de ladite antenne ;
- heure de la détection de ladite réponse ;
- azimut du faisceau principal de ladite antenne lors de ladite détection.

4. Procédé selon l'une quelconque des revendications précédentes, **caractérisé en ce que** la détection d'une réponse de type Fruit est enrichie par des informations obtenues à partir des réponses synchrones obtenues lors des tours entourant le tour de détection de ladite réponse de type Fruit, ces informations étant l'une au moins des caractéristiques suivantes :
- puissance relative de la dite réponse de type Fruit ;
- gisement de ladite réponse de type Fruit ;
- élévation de ladite réponse de type Fruit.

5. Procédé selon l'une quelconque des revendications précédentes, **caractérisé en ce que** sur le nombre de tours donné, on accumule dans des tableaux à deux entrées la puissance relative d'une réponse de type Fruit ou synchrone en fonction de la puissance de la cible sur le diagramme somme, un tableau étant associé à chaque diagramme d'antenne, une entrée étant le gisement en fonction de l'axe du lobe principal de l'antenne et une entrée étant l'élévation de la cible en fonction de l'horizontalité de l'antenne.

6. Procédé selon la revendication 5, **caractérisé en ce que** pour chaque cellule (gisement, élévation) de chaque diagramme la puissance relative la plus probable est établie par des méthodes du type moyenne, histogramme ou autres.

7. Procédé selon l'une quelconque des revendications précédentes, **caractérisé en ce que** le nombre de tours donné est défini pour laisser apparaître des dégradations en cours desdits diagrammes.

8. Procédé selon l'une quelconque des revendications précédentes, **caractérisé en ce que** l'antenne, équipant un radar secondaire du type ATC ou IFF, comporte au moins deux diagrammes.

9. Procédé selon l'une quelconque des revendications précédentes, **caractérisé en ce que** ladite antenne (1) est à balayage électronique, fixe ou tournante.

10. Procédé selon l'une quelconque des revendications précédentes, **caractérisé en ce que** la mesure desdits diagrammes est utilisée pour vérifier le niveau de dégradation desdits diagrammes.

11. Radar secondaire, **caractérisé en ce qu'**il est apte à mettre en œuvre le procédé selon l'une quelconque des revendications précédentes.

## Patentansprüche

1. Messverfahren von Antennendiagrammen (1) in Peilrichtung eines Sekundärradars pro Höhenbereich, wobei jedes Diagramm (11, 12, 14, 15) einem Empfangskanal (5) zugeordnet ist, **dadurch gekennzeichnet, dass** es die synchronen Antworten und die unerbetenen asynchronen Fruit-Antworten verwendet, welche durch die in der Luftumgebung des Radars vorhandenen Ziele gesendet werden, und welche über eine gegebene Anzahl von Antennenumdrehungen erkannt werden, wobei, bei jeder Erkennung einer Antwort, die Uhrzeit der Erkennung, der Azimutwert des Hauptstrahls (41) der Antenne und der empfangene Leistungswert auf jedem der Kanäle der Erkennung (21) zugeordnet werden, wobei jede asynchrone Antwort um ihre Peilrichtung, ihre relative Leistung pro Diagramm und ihre Höhe als Differenz zu denselben extrapolierten Werten der synchronen Antwort zur Fruit-Uhrzeit bereichert wird, wobei die erzielten Werte über die gegebene Anzahl von Umdrehungen gespeichert werden, wobei die gemessenen Diagramme anhand der gespeicherten Werte (22) abgetastet werden,
wobei für jede asynchrone Antwort eines Ziels folgende Daten berechnet werden:
- ihre Antennenpeilrichtung: durch Extrapolation der synchronen Azimutposition des Ziels zur Fruit-Erkennungsuhrzeit und der Azimutposition der Antenne zur Fruit-Erkennungsuhrzeit;
- ihre relative Leistung: durch Extrapolation der Leistung der synchronen Antworten, welche mit dem Hauptstrahl (41) des Summenkanals der Antenne erfasst werden, des Ziels, welche zeitlich die Fruit-Erkennungsuhrzeit zur Fruit-Erkennungsuhrzeit einrahmen, und der Fruit-Leistung auf jedem der Diagramme der Antenne;
- ihre Höhe: durch Extrapolation der Höhe, welche in den synchronen Antworten empfangen wurde, des Ziels, welche zeitlich die Fruit-Erkennungsuhrzeit zur Fruit-Erkennungsuhrzeit einrahmt.

2. Verfahren nach Anspruch 1, **dadurch gekennzeichnet, dass** die Antenne eine der folgenden Diagrammgruppen umfasst:
- ein Summendiagramm (SUM), ein Differenzdiagramm (DIFF), ein Kontrolldiagramm zur Unterdrückung der Antworten von Zielen vor der Antenne (CONT_Front) und ein Kontrolldiagramm zur Unterdrückung von Zielen hinter der Antenne (CONT_Back);
- ein Summendiagramm (SUM), ein Differenzdiagramm (DIFF) und ein Kontrolldiagramm (CONT);
- ein Summendiagramm (SUM) und ein Differenz- und Kontrolldiagramm (DIFF/CONT).

3. Verfahren nach einem der vorhergehenden Ansprüche, **dadurch gekennzeichnet, dass** die Fruit-Antworten und die synchronen Antworten um repräsentative Merkmale der Erfassung der Antworten bereichert werden, wobei die Merkmale für jede Antwort mindestens eines der folgenden Merkmale sind:
- empfangene Leistung entsprechend einem jeden Diagramm der Antenne;
- Erkennungsuhrzeit der Antwort;
- Azimut des Hauptstrahls der Antenne bei der Erkennung.

4. Verfahren nach einem der vorhergehenden Ansprüche, **dadurch gekennzeichnet, dass** die Erkennung einer Fruit-Antwort um Informationen bereichert wird, welche anhand der synchronen Antworten erzielt werden, welche bei den Umdrehungen, welche die Erkennungsumdrehung der Fruit-Antwort umgeben, erzielt wurden, wobei diese Informationen mindestens eines der folgenden Merkmale sind:
- relative Leistung der Fruit-Antwort;
- Peilrichtung der Fruit-Antwort;
- Höhe der Fruit-Antwort.

5. Verfahren nach einem der vorhergehenden Ansprüche, **dadurch gekennzeichnet, dass** man über die gegebene Anzahl von Umdrehungen in Tabellen mit zwei Eingängen die relative Leistung einer Fruit- oder einer synchronen Antwort in Abhängigkeit von der Leistung des Ziels auf dem Summendiagramm speichert, wobei eine Tabelle jedem Antennendiagramm zugeordnet ist, wobei ein Eintrag die Peilrichtung in Abhängigkeit von der Achse der Hauptkeule der Antenne ist und ein Eintrag die Höhe des Ziels in Abhängigkeit von der Horizontalität der Antenne ist.

6. Verfahren nach Anspruch 5, **dadurch gekennzeichnet, dass** für jede Zelle (Peilrichtung, Höhe) eines jeden Diagramms die wahrscheinlichste relative Leistung anhand von Verfahren wie Mittelung, Histogramm oder sonstigen Verfahren bestimmt wird.

7. Verfahren nach einem der vorhergehenden Ansprüche, **dadurch gekennzeichnet, dass** die gegebene Anzahl von Umdrehungen definiert wird, um Verschlechterungen im Verlauf der Diagramme sichtbar zu machen.

8. Verfahren nach einem der vorhergehenden Ansprüche, **dadurch gekennzeichnet, dass** die Antenne, welche einen Sekundärradar vom Typ ATC oder IFF ausgerüstet, mindestens zwei Diagramme umfasst.

9. Verfahren nach einem der vorhergehenden Ansprüche, **dadurch gekennzeichnet, dass** die Antenne (1) eine feste oder drehende Antenne mit elektronischer Abtastung ist.

10. Verfahren nach einem der vorhergehenden Ansprüche, **dadurch gekennzeichnet, dass** die Messung der Diagramme verwendet wird, um den Verschlechterungslevel der Diagramme zu überprüfen.

11. Sekundärradar, **dadurch gekennzeichnet, dass** er in der Lage ist, das Verfahren nach einem der vorhergehenden Ansprüche umzusetzen.

## Claims

1. A method for measuring the antenna patterns (1) in bearing of a secondary radar per elevation slice, each pattern (11, 12, 14, 15) being associated with a reception pathway (5), **characterized in that** it uses the synchronous responses and the asynchronous responses, unsolicited of Fruit type, transmitted by targets present in the aerial environment of said radar and detected over a given number of antenna revolutions, at each detection of a response, the time of said detection, the value of the azimuth of the main beam (41) of the antenna and the value of power received on each of said pathways being associated with said detection (21), each asynchronous response being enriched with its bearing, with its relative power per pattern and with its elevation by differencing with the extrapolated same values of said synchronous response at the time of the Fruit, said values obtained over the given number of revolutions being stored, the measured patterns being sampled from said stored values (22),
for each asynchronous response of a target, the following data being calculated:
- its antenna bearing: by extrapolation of the synchronous position of said target azimuth-wise at the Fruit detection time and of the position of the antenna azimuth-wise at the Fruit detection time;
- its relative power: by extrapolation of the power of said synchronous responses, acquired with the main beam (41) of the sum pathway of the antenna, of said target temporally bracketing the Fruit detection time at the time of the Fruit and of the power of the Fruit on each of the patterns of the antenna;
- its elevation: by extrapolation of the elevation, received in the synchronous responses, of said target temporally bracketing the Fruit detection time at the time of the Fruit.

2. The method according to claim 1, **characterized in that** said antenna has one of the following sets of patterns:
- a sum pattern (SUM), a difference pattern (DIFF), a control pattern for rejecting responses of targets facing the antenna (CONT_Front) and a control pattern for rejecting targets to the rear of the antenna (CONT_Back);
- a sum pattern (SUM), a difference pattern (DIFF), a control pattern (CONT);
- a sum pattern (SUM) and a difference and control pattern(DIFF/CONT).

3. The method according to any one of the preceding claims, **characterized in that** the Fruit-type responses and the synchronous responses are enriched by characteristics representative of the acquisition of said responses, said characteristics being, for each response, at least one of the following characteristics:
- power received according to each pattern of said antenna;
- time of the detection of said response;
- azimuth of the main beam of said antenna during said detection.

4. The method according to any one of the preceding claims, **characterized in that** the detection of a Fruit-type response is enriched by information obtained from the synchronous responses obtained during the revolutions surrounding the detection revolution of said Fruit-type response, this information being at least one of the following characteristics:
- relative power of said Fruit-type response;
- bearing of said Fruit-type response;
- elevation of said Fruit-type response.

5. The method according to any one of the preceding claims, **characterized in that** over the given number of revolutions, the relative power of a Fruit-type or synchronous response as a function of the power of the target on the sum pattern are accumulated in tables with two entries, a table being associated with each antenna pattern, one entry being the bearing as a function of the axis of the main lobe of the antenna and one entry being the elevation of the target as a function of the horizontality of the antenna.

6. The method according to claim 5, **characterized in that** for each cell (bearing, elevation) of each pattern the most probable relative power is established by methods of the mean, histogram or other type.

7. The method according to any one of the preceding claims, **characterized in that** the given number of revolutions is defined so as to reveal ongoing degradations of said patterns.

8. The method according to any one of the preceding claims, **characterized in that** the antenna, fitted to a secondary radar of the ATC or IFF type, has at least two patterns.

9. The method according to any one of the preceding claims, **characterized in that** said antenna (1) is a fixed or rotating electronically scanned antenna.

10. The method according to any one of the preceding claims, **characterized in that** the measurement of said patterns is used to verify the level of degradation of said patterns.

11. A Secondary radar, **characterized in that** it is able to implement the method according to any one of the preceding claims.
